# FASCICULE DE BREVET EUROPEEN

(11) **EP 0 669 796 B1**
(45) Date de publication et mention de la délivrance du brevet: **13.08.1997**
(21) Numéro de dépôt: 95400153.3
(22) Date de dépôt: 24.01.1995
(51) Int. Cl.: H05K 7/20, B60L 11/18

(54) **Dispositif de commande et de contrôle d'un moteur électrique, support utilisable dans un tel dispositif et utilisation de ce support pour la réalisation d'une batterie d'éléments d'accumulateurs électriques**
Regel- und Steuer-system eines elektrischen Motor, Tragvorrichtung des Systems und ihre Verwendung zur Verwirklichung einer Batterie mit Speicherzellen
Electric motor controlling device, carrier of the same and its use for making a cell elements battery

(30) Priorité: 28.02.1994 FR 9402275
(43) Date de publication de la demande: 30.08.1995
(73) Titulaire: AUTOMOBILES PEUGEOT, 75116 Paris (FR); AUTOMOBILES CITROEN, 92200 Neuilly-sur-Seine (FR)
(72) Inventeur: Bouton, Joel, F-95610 Eragny sur Oise (FR)
(74) Mandataire: Durand, Yves Armand Louis

(56) Documents cités:
- EP-A- 0 514 141
- WO-A-93/23266
- PATENT ABSTRACTS OF JAPAN vol. 17 no. 75 (E-1320) ,15 Février 1993 & JP-A-04 275492
- PATENT ABSTRACTS OF JAPAN vol. 13 no. 474 (E-836) ,26 Octobre 1989 & JP-A-01 186175

## Description

La présente invention concerne un dispositif de commande et de contrôle d'un moteur électrique, notamment pour un véhicule automobile.

La commande et le contrôle d'un moteur électrique sont effectués par l'intermédiaire d'éléments électriques, tels que par exemple des hacheurs, des convertisseurs, des chargeurs et des contacteurs, qui sont reliés d'une part à une source d'énergie et d'autre part à d'autres appareils électriques.

Patent Abstracts of Japan, Vol. 17, no. 75 [E-1320], 15 février 1993, révèle un refroidisseur pour des moyens de conversion de puissance d'un véhicule électrique.

On connaît déjà un dispositif de commande et de contrôle permettant de regrouper sur un même support un ensemble d'éléments électriques reliés entre eux et aptes à être connectés notamment à un moteur électrique et à une source d'énergie, lesdits éléments électriques étant en outre reliés par des canalisations à un circuit de refroidissement.

Dans ce dispositif connu, les canalisations hydrauliques de refroidissement sont fixées sur les éléments généralement par des colliers ou des étriers et la connexion électrique s'effectue par des liaisons électriques attachées aux éléments par l'intermédiaire de vis et d'écrous.

Cependant, la fixation précitée des canalisations de refroidissement est contraignante et onéreuse et des fuites de fluide peuvent survenir notamment à la suite des vibrations du moteur ou du véhicule.

D'autre part, les attaches précitées des liaisons électriques présentent également de nombreux inconvénients, notamment un risque de rupture d'alimentation ou de court-circuit par desserrage des attaches à la suite des vibrations du véhicule ou du moteur, ainsi qu'un risque d'échauffement des liaisons électriques et donc de pertes électriques consécutives à un mauvais serrage des attaches.

La présente invention a donc pour but d'éviter les inconvénients précités et de proposer un dispositif de commande et de contrôle d'un moteur électrique qui permet une connexion simple et rapide des éléments électriques sur un support, et qui présente une bonne isolation électrique ainsi qu'une bonne étanchéité au fluide de refroidissement.

A cet effet, la présente invention a pour objet un dispositif de commande et de contrôle d'un moteur électrique, notamment pour véhicule automobile, ledit dispositif comprenant un moyen de support pour des éléments électriques aptes à être connectés à une source d'énergie et à d'autres organes électriques par l'intermédiaire de liaisons électriques, et un réseau de canalisations véhiculant un fluide de refroidissement pour lesdits éléments électriques, caractérisé en ce que ledit moyen de support comprend une première partie métallique dans laquelle est formé ledit réseau, et une seconde partie en matériau isolant logeant lesdites liaisons électriques pour leur connexion avec lesdits éléments électriques, ladite source d'énergie et les autres organes électriques.

L'invention permet donc d'intégrer dans un même support à la fois le réseau hydraulique et les liaisons électriques.

Selon une caractéristique avantageuse de l'invention, le moyen de support présente sur une face supérieure des orifices de sortie et d'entrée de canalisations ménagés dans la première partie et des zones de contact électrique formées dans la seconde partie, permettant respectivement de relier hydrauliquement lesdites canalisations à des circuits de refroidissement formés dans des socles porte-éléments électriques et de connecter électriquement lesdites liaisons électriques aux éléments électriques montés sur lesdits socles, à ladite source d'énergie et aux autres organes électriques, chaque socle appartenant à une gamme de modules de formes prédéterminées et adaptées aux différents orifices et zones de contact du moyen de support.

Selon une autre caractéristique de l'invention, la seconde partie isolante est surmoulée sur la première partie métallique.

Selon encore une autre caractéristique de l'invention, chaque socle comporte avantageusement des moyens de fixation pour au moins un élément électrique et pour au moins un connecteur électrique apte à s'engager avec l'une desdites zones de contact pour assurer la connexion électrique entre lesdits éléments électriques et lesdites liaisons électriques.

L'invention permet donc de réaliser un dispositif modulaire assurant une connexion rapide et fiable des éléments électriques sur un même support.

Les connecteurs électriques précités peuvent comporter une embase mobile reliée élastiquement via des conducteurs aux éléments électriques par l'intermédiaire de ressorts et de tresses, pour assurer un contact fiable et rapide, ce qui évite de détériorer le moyen de support ou les connecteurs.

Selon une autre caractéristique de l'invention, chaque zone de contact se présente sous la forme d'un perçage débouchant à une extrémité sur une liaison électrique, son autre extrémité divergeant sensiblement, par exemple à la manière d'un tronc de cône, pour le guidage des embases des connecteurs électriques.

Des barreaux métalliques constituent avantageusement les liaisons électriques et sont encastrés au moins partiellement dans des logements longitudinaux de la seconde partie, de préférence dans des rainures ménagées sur la surface inférieure externe du moyen de support.

Le moyen de support peut éventuellement comporter sur sa face supérieure des moyens, tels que des goujons, pour la fixation des socles porte-éléments électriques.

Le dispositif de l'invention peut également comporter des moyens mécaniques de fixation du moyen de support notamment sur un véhicule automobile.

La présente invention a également pour objet un support tel que celui qui vient d'être décrit ci-dessus. Le support peut avantageusement être utilisé pour la réalisation d'une batterie d'éléments accumulateurs électriques, chaque élément étant monté sur le support de la même manière que les éléments électriques précités.

L'invention sera mieux comprise et d'autres buts, caractéristiques, détails et avantages de celle-ci apparaîtront plus clairement au cours de la description explicative qui va suivre de deux modes de réalisation particuliers actuellement préférés de l'invention, donnés uniquement à titre d'exemples illustratifs et non limitatifs, en référence aux dessins schématiques annexés, dans lesquels.

La figure 1 est une vue de dessus du moyen de support du dispositif de l'invention.

La figure 2 est une vue en élévation latérale du dispositif de l'invention.

La figure 3 est une vue en perspective d'un premier mode de réalisation d'un module du dispositif de l'invention.

La figure 4 est une vue en coupe transversale du dispositif de l'invention, suivant la ligne IV-IV de la figure 2.

La figure 5 est une vue en coupe transversale et partielle d'un second mode de réalisation du dispositif de l'invention, suivant la ligne V-V de la figure 2.

La figure 6 est une vue en coupe transversale et partielle du dispositif de l'invention, suivant la ligne VI-VI de la figure 2.

La figure 7 est un schéma synoptique fonctionnel du dispositif de l'invention pour un véhicule automobile.

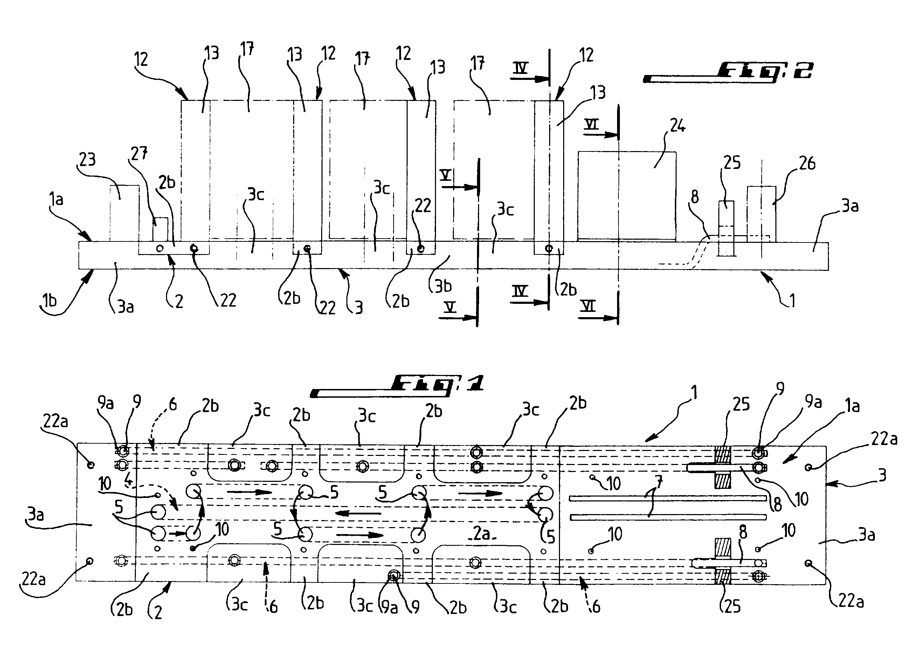

Suivant l'exemple de réalisation représenté sur la figure 1, le dispositif de l'invention comporte une plaque ou semelle de support 1 constituée d'une première partie métallique 2, par exemple en aluminium, sur laquelle a été surmoulée une seconde partie en matériau isolant 3.

Bien entendu, la seconde partie isolante peut être réalisée par injection ou par un procédé autre que le surmoulage.

On a représenté en premier plan sur la figure 1 la face supérieure 1a de la plaque de support 1.

La première partie métallique 2 présente un corps central longitudinal 2a duquel font saillie latéralement, au niveau de la face supérieure 1a, des pattes 2b, ces dernières étant espacées les unes des autres dans la direction longitudinale de la plaque 1 suivant un écartement qui peut être de longueur variable.

La seconde partie isolante 3 présente une forme complémentaire qui vient s'adapter en partie sous la première partie métallique 2. Cette deuxième partie isolante 3 comporte deux portions d'extrémité 3a qui viennent enserrer longitudinalement la première partie métallique 2, lesdites portions d'extrémité 3a étant reliées par deux portions latérales intermédiaires 3b qui viennent enserrer latéralement le corps central 2a de la première partie métallique 2. Les portions latérales intermédiaires 3b présentent des protubérances 3c qui font saillie vers la face supérieure la entre les pattes 2b précitées.

Un réseau hydraulique de canalisations 4 est ménagé dans le corps central 2a de ladite première partie métallique 2, par exemple lors du moulage ou par usinage de celle-ci.

Ces canalisations 4 débouchent sur la face supérieure la par l'intermédiaire d'orifices 5 de sortie et d'entrée de fluide de refroidissement, lesdits orifices de sortie et d'entrée étant respectivement disposés à chaque extrémité des canalisations.

On a représenté sur la figure 1, à titre d'exemple illustratif et non limitatif, le trajet et le sens de circulation du fluide de refroidissement à l'intérieur du réseau de canalisations 4, matérialisés par des flèches.

Des rainures longitudinales 6 sont formées dans les portions latérales 3b de la seconde partie isolante 3 au niveau de la face inférieure 1b. D'autres rainures longitudinales 7 sont ménagées dans l'une des portions d'extrémité 3a de la seconde partie isolante 3 au niveau de la face supérieure 1a.

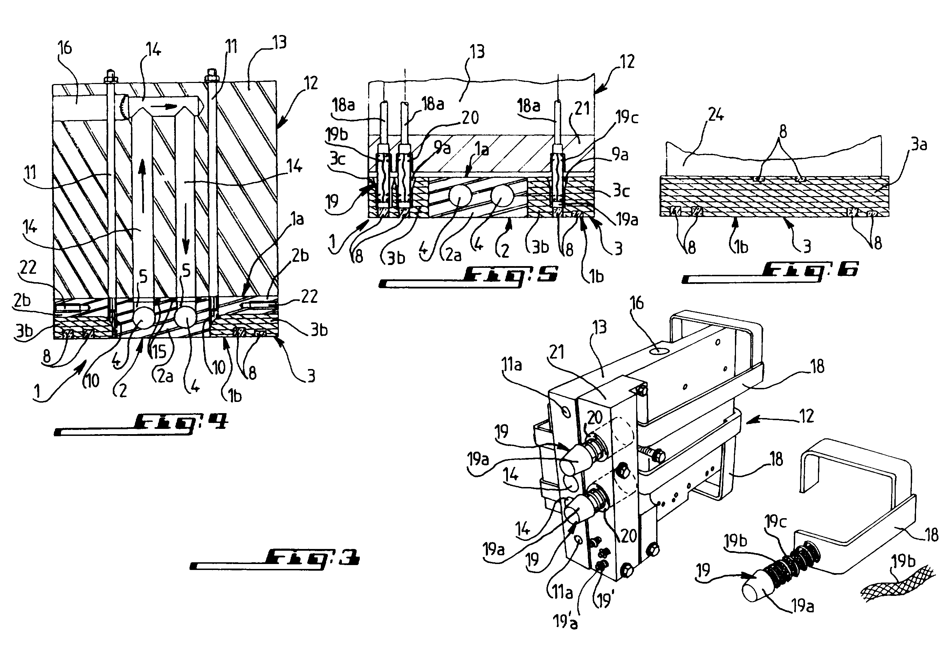

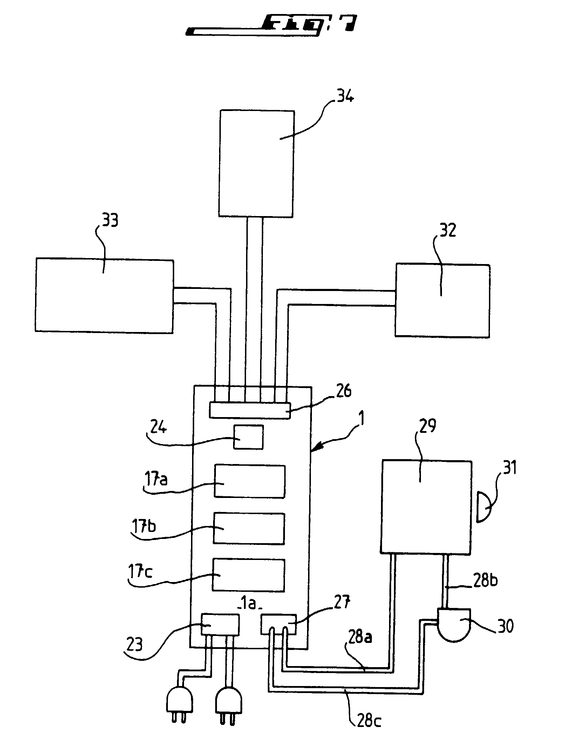

Ces rainures longitudinales 6 et 7 sont destinées à recevoir des barres 8 d'alimentation en énergie et de conduction de courant électrique, dont l'intensité est variable et peut aller jusqu'à 300A (voir figures 4 à 6).

Les barres 8 peuvent être encastrées dans lesdites rainures ou incorporées dans la seconde partie isolante 3 lors du surmoulage.

Des perçages 9, ménagés à travers l'épaisseur de la seconde partie isolante 3, débouchent au niveau de leur extrémité inférieure dans les rainures longitudinales 6 et présentent une extrémité supérieure divergente, par exemple en forme de tronc de cône 9a, au niveau de la face supérieure 1a.

La face supérieure 1a de la plaque de support 1 comporte des taraudages 10 pour recevoir les extrémités inférieures de goujons 11 de fixation de modules 12 sur la plaque de support 1.

Chaque module 12 est constitué d'un socle ou platine 13 sensiblement en forme de plaque et orienté sur les dessins verticalement, lesdits goujons 11 étant constitués d'une tige allongée traversant lesdits socles 13 dans le sens de la hauteur.

Bien entendu, les goujons 11 peuvent être remplacés par tout autre moyen de fixation adapté, tel que des vis ou analogues.

En se référant maintenant à la figure 4, on voit que des conduits 14 sont formés dans le socle 13 et aptes à être reliés hydrauliquement à des orifices d'entrée et de sortie 5 des canalisations précitées 4 de manière à former un circuit fermé de circulation de fluide de refroidissement. On a également représenté à titre d'exemple sur la figure 4 le sens et le trajet de circulation du fluide de refroidissement à l'intérieur des conduits 14 conformément à la figure 1 (matérialisés par des flèches).

Des joints d'étanchéité 15 sont prévus entre le socle 13 et les orifices 5 pour éviter toute fuite de fluide au niveau de leurs zones de jonction.

Sur la figure 4, les conduits 14 sont agencés de manière à former un circuit en forme de U, dont le conduit intermédiaire 14 est obtenu par usinage et obturé par un bouchon 16.

Le fluide de refroidissement circulant dans les conduits 14 est destiné à refroidir les modules 12 et en particulier les éléments électriques 17 montés sur lesdits socles 13. Ces éléments électriques 17 sont représentés schématiquement en traits mixtes sur la figure 2.

Ces éléments électriques sont interchangeables et peuvent être adaptés sur les différents modules. A titre d'exemple, on peut citer en tant qu'éléments électriques des hacheurs, des convertisseurs ou des chargeurs.

On voit sur la figure 3 que ces éléments électriques peuvent être montés de part et d'autre du socle 13 et être reliés aux autres organes électriques par des barres conductrices 18 servant éventuellement de moyen de fixation.

On voit sur les figures 3 et 5, qui représentent deux modes de réalisation d'un module de l'invention, que chaque module 12 comporte plusieurs connecteurs électriques 19 aptes à s'engager dans les perçages 9 de la plaque de support 1, l'extrémité tronconique 9a de ces perçages 9 assurant le guidage de ces connecteurs 19.

Ces connecteurs 19 sont reliés par une ligne électrique 18a ou par une barre conductrice 18 aux éléments électriques 17 et assurent la connexion électrique entre les éléments électriques 17 et les barres 8 d'alimentation en énergie.

On a représenté sur la figure 3 des connecteurs du type "Maréchal" qui comportent une tresse 19b traversant axialement un ressort hélicoïdal 19c qui de concert avec celle-ci relie élastiquement une embase mobile 19a du connecteur 19 à un des éléments électriques précités. Le connecteur 19 est fixé sur une embase fixe et isolante 21 et la traverse par un puits de centrage 20.

On a représenté sur la figure 3 deux connecteurs 19 de taille relativement grande par rapport à trois petits connecteurs 19' à embase 19'a, de taille relativement petite servant à passer respectivement les courants de forte intensité et les faibles courants de commande.

On peut également prévoir un autre connecteur 19 détachable de manière à pouvoir adapter chaque module 12 aux différents éléments électriques 17.

On voit également sur la figure 3 des trous 11a traversant le socle 13 et permettant le passage des goujons 11.

On a représenté sur les figures 2 et 4 des taraudages 22 ménagés dans les pattes latérales 2b pour la fixation mécanique de la plaque de support 1, notamment sur un véhicule automobile.

En se référant maintenant à la figure 2, on voit une prise de charge 23 disposée sur l'une des portions d'extrémité 3a de la seconde partie isolante 3 au niveau de perçages 9 pour alimenter en énergie les différents éléments électriques 17 ainsi que d'autres organes électriques par l'intermédiaire des barres métalliques 8.

Un contacteur principal 24 est disposé sur l'autre portion d'extrémité 3a au niveau des rainures longitudinales 7.

On a également prévu sur la plaque de support 1 des capteurs 25 pour mesurer l'intensité du courant circulant dans les barres métalliques d'alimentation 8, ces capteurs 25 étant disposés à la sortie desdites barres 8 au niveau de la face supérieure 1a.

Une interface de liaison électrique 26 est prévue sur cette dernière portion d'extrémité 3a pour relier les différentes barres 8 à d'autres organes électriques.

Une interface de connexion hydraulique 27 est disposée en regard des orifices principaux d'entrée et de sortie 5 qui servent à l'alimentation du dispositif de l'invention en fluide de refroidissement.

On va maintenant décrire le fonctionnement du dispositif de l'invention en se référant au schéma synoptique fonctionnel illustré sur la figure 7.

On a représenté sur la figure 7 trois éléments électriques 17a, 17b et 17c représentant respectivement des hacheurs, un convertisseur et un chargeur.

L'interface de connexion hydraulique 27 est reliée par une canalisation 28a à un radiateur de refroidissement 29 qui est à son tour relié par une canalisation 28b à une pompe auxiliaire 30, une canalisation 28c reliant ladite pompe auxiliaire 30 à l'interface de connexion hydraulique 27.

Les canalisations 28a et 28c sont respectivement connectées hydrauliquement à un orifice d'entrée et à un orifice de sortie 5 dudit réseau hydraulique de canalisations 4.

Le radiateur 29 est refroidi par un moto-ventilateur 31.

La prise de charge 23 est alimentée en tension, par exemple en 220V. Elle peut regrouper deux alimentations, l'une à courant fort, par exemple 200A, et l'autre à courant faible, par exemple 16A.

L'interface de liaison électrique 26 est reliée à d'autres organes, par exemple des organes d'un véhicule automobile, tels qu'un moteur 32, une batterie principale de puissance 33 et une batterie auxiliaire 34.

Le dispositif de l'invention est donc particulièrement adapté à des véhicules à moteur électrique.

Le dispositif de l'invention est réalisé de manière à pouvoir supporter le passage de courants de forte intensité dans les barres métalliques 8.

Il apparaît clairement de ce qui précède que les différents modules, et donc les éléments électriques, peuvent être montés et démontés rapidement et facilement.

En outre, le dispositif de l'invention assure une bonne isolation électrique vis-à-vis des éléments externes, étant donné que les barres d'alimentation électrique 8 sont intégrées dans un matériau isolant.

## Revendications

1. Dispositif de commande et de contrôle d'un moteur électrique, notamment pour véhicule automobile, ledit dispositif comprenant un moyen de support (1) pour des éléments électriques (17) aptes à être connectés à une source d'énergie et à d'autres organes électriques par l'intermédiaire de liaisons électriques (8) et un réseau de canalisations (4) véhiculant un fluide de refroidissement pour lesdits éléments électriques, caractérisé en ce que ledit moyen de support (1) comprend une première partie métallique (2) dans laquelle est formé ledit réseau (4), et une seconde partie en matériau isolant (3) logeant lesdites liaisons électriques (8) pour leur connexion avec lesdits éléments électriques (17), ladite source d'énergie (23) et les autres organes électriques (32, 33, 34).

2. Dispositif selon la revendication 1, caractérisé en ce que le moyen de support (1) présente sur une face supérieure (1a) des orifices de sortie et d'entrée (5) de canalisations ménagés dans la première partie (2) et des zones de contact électrique (9) formées dans la seconde partie (3), permettant respectivement de relier hydrauliquement lesdites canalisations (4) à des circuits de refroidissement (14) formés dans des socles porte-éléments électriques (13) et de connecter électriquement lesdites liaisons électriques (8) aux éléments électriques (17) montés sur lesdits socles (13), à ladite source d'énergie (23) et aux autres organes électriques (32, 33, 34), chaque socle (13) appartenant à une gamme de modules (12) de formes prédéterminées et adaptées aux différents orifices (5) et zones de contact (9) du moyen de support (1).

3. Dispositif selon la revendication 2, caractérisé en ce que chaque socle (13) comporte des moyens de fixation (21) pour au moins un élément électrique (17) et pour au moins un connecteur électrique (19, 19') apte à s'engager avec l'une desdites zones de contact (9) pour assurer la connexion électrique entre lesdits éléments électriques (17) et lesdites liaisons électriques (8).

4. Dispositif selon la revendication 3, caractérisé en ce que les connecteurs électriques (19, 19') comportent une embase mobile (19a) reliée élastiquement via des conducteurs (18, 18a) aux éléments (17) par l'intermédiaire de ressorts (19c) et de tresses (19b).

5. Dispositif selon la revendication 4, caractérisé en ce que chaque zone de contact (9) se présente sous la forme d'un perçage débouchant à une extrémité sur une liaison électrique (8), son autre extrémité (9a) divergeant sensiblement, par exemple à la manière d'un tronc de cône, pour le guidage des embases (19a, 19'a) des connecteurs électriques (19, 19').

6. Dispositif selon l'une quelconque des revendications 2 à 5, caractérisé en ce que le moyen de support (1) comporte sur sa face supérieure (1a) des moyens (10, 11), tels que des goujons, pour la fixation des socles porte-éléments électriques (13).

7. Dispositif selon l'une quelconque des revendications précédentes, caractérisé en ce que la seconde partie isolante (3) est surmoulée sur la première partie métallique (2).

8. Dispositif selon l'une quelconque des revendications précédentes, caractérisé en ce que des barreaux métalliques (8) constituent les liaisons électriques et sont encastrés au moins partiellement dans des logements longitudinaux (6, 7) de la seconde partie isolante (3), de préférence dans des rainures (6) ménagées sur la surface inférieure externe (1b) du moyen de support (1).

9. Dispositif selon l'une quelconque des revendications précédentes, caractérisé en ce qu'il comporte des moyens mécaniques (22) de fixation du moyen de support (1), notamment sur un véhicule automobile.

10. Dispositif selon l'une des revendications précédentes, caractérisé en ce le moyen de support précité (1) est utilisé pour la réalisation d'une batterie d'éléments d'accumulateurs électriques, chaque élément étant monté sur ledit moyen de support de la même manière que les éléments électriques (17).

## Patentansprüche

1. Vorrichtung zur Betätigung und zur Kontrolle eines elektrischen Motors, insbesondere für ein Kraftfahrzeug, wobei die besagte Vorrichtung ein Tragmittel (1) für elektrische Elemente (17), die geeignet sind, an eine Energiequelle und an andere elektrischen Glieder über elektrische Verbindungen (8) angeschloßen zu werden und ein Netz von ein fließfähiges Kühlmittel für die besagten elektrischen Elemente leitenden Kanälen (4) aufweist, dadurch gekennzeichnet, daß das besagte Tragmittel (1) einen ersten metallischen Teil (2), in welchem das besagte Netz (4) gebildet ist und einen zweiten Teil aus isolierendem Werkstoff (3), der die besagten elektrischen Verbindungen (8) für deren Anschluß an die besagten elektrischen Elemente (17), an die besagte Energiequelle (23) und an die anderen elektrischen Glieder (32, 33, 34) umfaßt.

2. Vorrichtung nach Anspruch 1, dadurch gekennzeichnet, daß das Tragmittel (1) an einer oberen Fläche (la) in dem ersten Teil (2) gebildete Austritt- und Eintrittöffnungen (5) von Kanälen und in dem zweiten Teil (3) gebildete elektrische Kontaktbereiche (9) aufweist, welche es gestatten, die besagten Kanäle (4) jeweils mit in elektrische Elemente tragenden Grundhaltern (13) gebildeten Kühlkreislaufschaltungen (14) hydraulisch zu verbinden und die besagten elektrischen Anschlüße (8) mit den an den besagten Grundhaltern (13) angeordneten Elementen (17), mit der besagten Energiequelle (23) und mit den anderen elektrischen Gliedern (32, 33, 34) elektrisch zu verbinden, wobei jeder Grundhalter (13) zu einer Reihe von an die verschiedenen Öffnungen (5) und Kontaktbereiche (9) des Tragmittels (1) angepaßten Modulen (12) mit vorbestimmten Gestaltungen gehört.

3. Vorrichtung nach Anspruch 2, dadurch gekennzeichnet, daß jeder Grundhalter (13) Befestigungsmittel (21) für wenigstens ein elektrisches Element (17) und für wenigstens einen elektrischen Verbinder (19, 19'), der geeignet ist, mit dem einen der besagten Kontaktbereiche (9) in Eingriff zu kommen, um die elektrische Verbindung zwischen den besagten elektrischen Elementen (17) und den besagten elektrischen Anschlüßen (8) zu gewährleisten, aufweist.

4. Vorrichtung nach Anspruch 3, dadurch gekennzeichnet, daß die elektrischen Verbinder (19, 19') ein über Leiter (18, 18a) mit den Elementen (17) über Federn (19c) und Flechten (19b) elastisch verbundenes bewegbares Endstück (19a) aufweisen.

5. Vorrichtung nach Anspruch 4, dadurch gekennzeichnet, daß jeder Bereich (9) in der Gestalt einer an einem Ende auf einen elektrischen Anschluß (8) ausmündenden Bohrung vorliegt, wobei sein anderes Ende (9a) z.B. in der Weise eines Kegelstumpfes für die Führung der Endstücke (19a, 19'a) der elektrischen Leiter (19, 19') wesentlich auseinanderläuft.

6. Vorrichtung nach irgendeinem der Ansprüche 2 bis 5, dadurch gekennzeichnet, daß das Tragmittel (1) an seiner oberen Fläche (la) Mittel (10, 11), wie Stiftbolzen zur Befestigung der die elektrischen Elemente tragenden Grundhalter (13) aufweist.

7. Vorrichtung nach irgendeinem der vorangehenden Ansprüche, dadurch gekennzeichnet, daß der zweite isolierende Teil (3) auf dem ersten metallischen Teil (2) übergeformt ist.

8. Vorrichtung nach irgendeinem der vorangehenden Ansprüche, dadurch gekennzeichnet, daß Metallstäbe (8) die elektrischen Verbindungen bilden und in Längsaufnahmen (6, 7) des zweiten isolierenden Teiles (3), vorzugsweise in an der unteren Außenfläche (1b) des Tragmittels (1) gebildeten Nuten (6) wenigstens teilweise eingefaßt sind.

9. Vorrichtung nach irgendeinem der vorangehenden Ansprüche, dadurch gekennzeichnet, daß sie mechanische Mittel (22) zur Befestigung des Tragmittels (1) insbesondere an einem Kraftfahrzeug aufweist.

10. Vorrichtung nach irgendeinem der vorangehenden Ansprüche, dadurch gekennzeichnet, daß das vorgenannte Tragmittel (1) zur Herstellung einer Batterie von elektrischen Stromsammlerelementen verwendet wird, wobei jedes Element an dem besagten Tragmittel in derselben Weise wie die elektrischen Elemente (17) angeordnet ist.

## Claims

1. Device for the operation and control of an electric motor in particular for an automotive vehicle, the said device comprising a means (1) for supporting electrical elements (17) adapted to be connected to an energy source and to other electrical members through the medium of electrical connections (8) and a system of ducts (4) conveying a cooling fluid for the said electrical elements, characterized in that the said supporting means (1) comprises a first metal portion (2) in which is formed the said system (4) and a second portion of insulating material (3) accommodating the said electrical connections (8) for their connection with the said electrical elements (17), the said energy source (23) and the other electrical members (32, 33, 34).

2. Device according to claim 1, characterized in that the supporting means (1) exhibits on a top face (la) inlet and outlet ports (5) for the ducts formed in the first portion (2) and electrical contact zones (9) formed in the second portion (3), permitting to hydraulically connect the said ducts (4) to cooling circuits (14), respectively, formed in electrical elements-carrying base brackets (13) and to electrically connect the said electrical connections (8) to the electrical elements (17) mounted onto the said base brackets (13), to the said energy source (23) and to the other electrical members (32, 33, 34), each base bracket (13) belonging to a range of modules (12) with predetermined shapes and adapted to the different ports (5) and contact zones (9) of the supporting means (1).

3. Device according to claim 2, characterized in that each base bracket (13) comprises fastening means (21) for at least one electrical element (17) and for at least one electrical connector (19, 19') adapted to engage one of the said contact zones (9) to provide the electrical connection between the said electrical elements (17) and the said electrical connections (8).

4. Device according to claim 3, characterized in that the electrical connectors (19, 19') comprise a movable end piece (19a) elastically connected via conductors (18, 18a) to the elements (17) through the medium of springs (19c) and of straps (19b).

5. Device according to claim 4, characterized in that each contact zone (9) presents itself in the shape of a bore opening at one end onto an electrical connection (8), its other end (9a) substantially diverging for example in the manner of a frustum of a cone for the guiding of the end pieces (19a, 19'a) of the electrical connectors (19, 19').

6. Device according to any one of claims 2 to 5, characterized in that the support means (1) comprises on its top face (la) means (10, 11) such as studs for the fastening of the electrical elements-carrying base-brackets (13).

7. Device according to any one of the foregoing claims, characterized in that the second insulating portion (3) is molded over and about the first metal portion (2).

8. Device according to any one of the foregoing claims, characterized in that metal bars (8) constitute the electrical connections and are at least partially fitted into longitudinal recesses (6, 7) of the second insulating portion (3) preferably into grooves (6) formed on the external bottom face (1b) of the supporting means (1).

9. Device according to any one of the foregoing claims, characterized in that it comprises mechanical means (22) for the fastening of the supporting means (1) in particular onto an automotive vehicle.

10. Device according to one of the foregoing claims, characterized in that the aforesaid supporting means (1) is used for the provision of a bank of electrical storage battery elements, each element being mounted onto the supporting means in the same manner as the electrical elements (17).
